# FASCICULE DE BREVET EUROPEEN

(11) **EP 2 535 932 B1**
(45) Date de publication et mention de la délivrance du brevet: **19.03.2014**
(21) Numéro de dépôt: 12168455.9
(22) Date de dépôt: 18.05.2012
(51) Int. Cl.: H01L 23/58, H01L 21/763

(54) **Puce de circuit intégré comprenant un dispositif de protection contre des attaques**
Chip mit einem integrierten Schaltkreis und einer Schutzvorrichtung gegen Angriffe
Integrated circuit chip comprising protecting means against attacks

(30) Priorité: 17.06.2011 FR 1155342
(43) Date de publication de la demande: 19.12.2012
(73) Titulaire: STMicroelectronics (Rousset) SAS, 13790 Rousset (FR)
(72) Inventeur: Lisart, Mathieu, 13100 Aix en Provence (FR); Sarafianos, Alexandre, 13014 Marseille (FR)
(74) Mandataire: de Beaumont, Michel

(56) Documents cités:
- EP-A2- 2 109 139
- US-A- 4 862 240
- US-A- 6 010 939
- US-A1- 2006 180 939
- US-A1- 2010 187 525

## Description

### Domaine de l'invention

La présente invention concerne la protection d'une puce de circuit intégré contre des attaques visant à obtenir des informations confidentielles protégées.

### Exposé de l'art antérieur

Dans certains dispositifs sécurisés tels que des cartes de paiement, des puces de circuits intégrés sont susceptibles de traiter et/ou de stocker des données sensibles, par exemple des clés de chiffrement. Ces puces peuvent faire l'objet de manipulations frauduleuses visant à obtenir des informations confidentielles protégées.

Parmi les attaques connues, les attaques dites "attaques par faute", consistent à perturber volontairement le fonctionnement de la puce, et à analyser l'influence des perturbations sur son comportement. L'attaquant s'intéresse notamment à l'influence des perturbations sur des données telles que des signaux de sortie, la consommation, ou des temps de réponse. Il est susceptible d'en déduire, par des études statistiques ou autres, des informations sensibles telles que des algorithmes mis en oeuvre par la puce et éventuellement des clés de chiffrement.

Pour provoquer volontairement des anomalies dans les circuits d'une puce, un mode d'attaque consiste à bombarder des zones de la puce par un faisceau laser alors que la puce est en fonctionnement. On peut ainsi injecter des fautes dans certaines cellules mémoires et/ou affecter le comportement de certains composants. En raison de la présence de pistes métalliques d'interconnexion du côté de la face avant du substrat, les attaques laser sont le plus souvent réalisées par la face arrière de la puce. L'attaquant prévoit généralement une étape préliminaire d'amincissement du substrat de la puce, afin de réduire l'atténuation du faisceau par le substrat et donc d'améliorer l'efficacité de l'attaque.

Pour se prémunir contre les fraudes, on a proposé des puces comprenant un dispositif de détection d'attaque, couplé à un circuit de protection de la puce. Lorsqu'une attaque est détectée, le circuit de protection met en oeuvre des mesures de protection, d'aliénation, ou de destruction des données sensibles. Par exemple, on peut prévoir, lorsqu'une attaque est détectée, d'interrompre l'alimentation de la puce ou de provoquer sa réinitialisation, de façon à minimiser le temps pendant lequel l'attaquant peut étudier la réponse de la puce à une perturbation.

Les solutions de détection d'attaque peuvent être logiques. Elles consistent par exemple à introduire régulièrement dans les calculs des tests d'intégrité permettant de s'assurer que des données n'ont pas été modifiées. Ces solutions présentent l'inconvénient d'introduire des étapes de calcul supplémentaires, augmentant ainsi les temps de réponse de la puce. En outre, les tests d'intégrité ne peuvent pas détecter toutes les perturbations provoquées par un attaquant. Ce dernier dispose donc d'une certaine marge de manoeuvre susceptible de lui permettre d'acquérir des informations sensibles.

D'autres solutions de détection d'attaque, dites physiques, comportent des capteurs sensibles aux variations de température, aux ultraviolets, ou aux rayons X, permettant de déceler des activités suspectes. De même que les solutions logiques, ces solutions ne sont pas parfaitement fiables. En effet, avant la détection de l'attaque, l'attaquant dispose d'une marge de manoeuvre susceptible de lui permettre d'obtenir des informations sensibles. De plus, la mise en oeuvre de ces solutions est complexe et augmente la surface de silicium nécessaire à la réalisation de la puce.

Un autre exemple d'attaque consiste à graver localement le substrat de la puce depuis sa face arrière jusqu'à atteindre la partie active du substrat, c'est-à-dire la couche supérieure de substrat dans laquelle sont formés les transistors de la puce. La gravure locale du substrat peut consister à graver, depuis la face arrière, des ouvertures successives de plus en plus profondes et étroites, les dernières ouvertures étant réalisées au moyen d'un faisceau d'ions focalisé ou FIB (de l'anglais "Focused Ion Beam"). A titre d'exemple, l'attaquant peut "ouvrir" une zone sensiblement circulaire de quelques dizaines de micromètres à quelques centaines de micromètres de diamètre, dont le fond affleure la partie active de la puce. A l'issue de cette étape, il ne reste plus qu'une mince épaisseur de substrat, par exemple de l'ordre de 0,5 à 1,5 µm, entre le fond de l'ouverture et l'empilement de couches isolantes et de pistes métalliques d'interconnexion revêtant la face avant du substrat. L'attaquant forme alors des trous de faible diamètre, par exemple de l'ordre de quelques centaines de nanomètres de diamètre, reliant le fond de l'ouverture à des pistes métalliques d'interconnexion du circuit disposées du côté de la face avant du substrat, et/ou à des zones actives du circuit telles que des régions de source ou de drain de transistors MOS. Les trous sont remplis d'un matériau conducteur tel que le tungstène pour former des vias. Des plots de contact sont formés sur le fond de l'ouverture, chaque plot recouvrant l'un des vias. Une telle attaque permet ainsi d'accéder à des signaux présents dans des pistes du ou des premiers niveaux de métallisation du circuit intégré, et/ou dans des zones actives du circuit intégré.

Un exemple connu de dispositif de protection d'un circuit intégré contre une attaque laser est décrit dans la demande de brevet EP2109139.

### Résumé

Ainsi, un objet d'un mode de réalisation de la présente invention est de proposer un dispositif de protection d'une puce de circuit intégré contre des attaques, palliant au moins en partie certains des inconvénients des solutions existantes.

Un objet d'un mode de réalisation de la présente invention est de prévoir un dispositif de protection permettant de détecter une gravure localisée du substrat de la puce, du type réalisé lors d'une attaque par prise de contact depuis la face arrière de la puce.

Un objet d'un mode de réalisation de la présente invention est de proposer un dispositif de protection permettant en outre d'empêcher l'injection de fautes dans les circuits de la puce, notamment à l'aide d'un laser.

Ainsi, la présente invention prévoit une puce de circuit intégrée selon la revendication 1 comprenant une pluralité de caissons parallèles de types de conductivité alternés, formés dans la partie supérieure d'un substrat semiconducteur d'un premier type de conductivité, et un dispositif de protection contre des attaques comprenant : entre les caissons, des tranchées à parois isolées remplies d'un matériau conducteur, les tranchées s'étendant depuis la face supérieure des caissons jusqu'au substrat ; et un circuit adapté à détecter une modification de la capacité parasite formée entre ledit matériau conducteur et une région de la puce.

Selon un mode de réalisation de la présente invention, la région de puce susmentionnée est choisie de façon que la capacité parasite soit modifiée lorsque le substrat de la puce est gravé localement depuis sa face arrière.

Selon un mode de réalisation de la présente invention, la puce comprend en outre une couche du second type de conductivité, s'étendant sous la pluralité de caissons, entre la face inférieure des caissons et le substrat.

Selon un mode de réalisation de la présente invention, la profondeur des tranchées est supérieure à 2 µm.

Selon un mode de réalisation de la présente invention, le matériau conducteur est du silicium polycristallin.

Selon un mode de réalisation de la présente invention, le circuit comprend un oscillateur dont la fréquence de résonnance dépend de la valeur de la capacité parasite, et des moyens de comparaison de la fréquence de résonnance à une valeur de référence.

Selon un mode de réalisation de la présente invention, la région de puce susmentionnée est le substrat de la puce.

Selon un mode de réalisation de la présente invention, la région de puce susmentionnée est une prise de contact de polarisation d'un caisson du premier type de conductivité.

Selon un mode de réalisation de la présente invention, la puce comprend, dans chaque caisson du premier type, une pluralité de transistors MOS à canal du second type de conductivité, et dans chaque caisson du second type, une pluralité de transistors MOS à canal du premier type, des transistors voisins de caissons voisins étant reliés en inverseurs.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1A est une vue de dessus représentant de façon schématique et partielle un exemple de réalisation d'une puce de circuit intégré connue de l'état de la technique;
les figures 1B, 1C et 1D sont des vues en coupe selon les plans A-A, B-B et C-C de la figure 1A ;
la figure 2A est une vue de dessus représentant de façon schématique et partielle un mode de réalisation selon l'invention d'une puce de circuit intégré protégée contre des attaques ;
les figures 2B, 2C et 2D sont des vues en coupe selon les plans A-A, B-B et C-C de la figure 2A ; et
la figure 3 est une vue en coupe schématique d'un mode de réalisation selon l'invention d'une puce de circuit intégré protégée contre des attaques, comportant un dispositif de détection d'une gravure localisée du substrat de la puce depuis sa face arrière.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

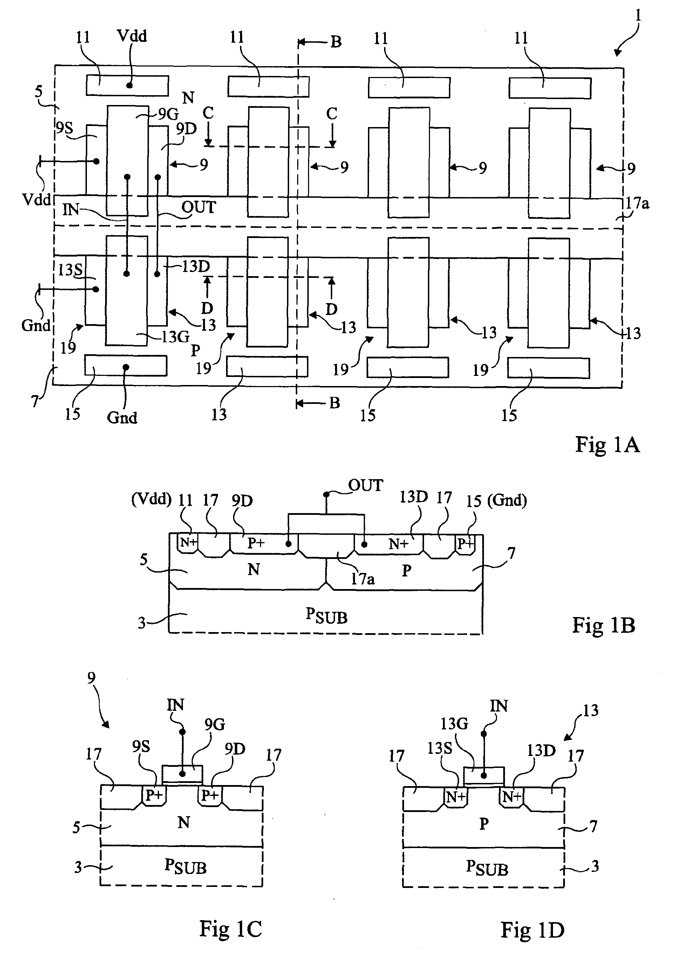

Les figures 1A à 1D représentent de façon schématique et partielle un exemple d'une puce 1 de circuit intégré connue de l'état de la technique. La figure 1A est une vue de dessus de la puce 1, et les figures 1B, 1C et 1D sont des vues en coupe, respectivement selon les plans A-A, B-B et C-C de la figure 1A.

La puce 1 est formée à partir d'un substrat semiconducteur 3 (P_{SUB}) faiblement dopé de type P, par exemple un substrat de silicium. Des caissons juxtaposés de types de conductivité alternés sont formés dans la partie supérieure du substrat 3. Dans cet exemple, seuls deux caissons 5 et 7 ont été représentés, respectivement de type N et de type P, ayant en vue de dessus la forme de bandes parallèles juxtaposées (en traits pointillés sur la figure 1A). En pratique, la puce 1 peut comprendre un grand nombre de caissons parallèles juxtaposés de type de conductivité alternés.

Le caisson 5, de type N, comprend une pluralité de transistors MOS à canal P 9. Chaque transistor 9 comprend des régions de source 9S et de drain 9D, fortement dopées de type P (P+), délimitées par une grille conductrice isolée 9G formée à la surface du caisson 5. Le caisson 5 comprend en outre une pluralité de régions 11 fortement dopées de type N, formant des prises de contact de polarisation du caisson. Dans cet exemple, une prise de contact 11 est disposée au voisinage de chaque transistor 9.

Le caisson 7, de type P, comprend une pluralité de transistors MOS à canal N 13. Chaque transistor 13 comprend des régions de source 13S et de drain 13D, fortement dopées de type N (N+), délimitées par une grille conductrice isolée 13G formée à la surface du caisson 7. Le caisson 7 comprend en outre une pluralité de régions 15 fortement dopées de type P, formant des prises de contact de polarisation du caisson. Dans cet exemple, une prise de contact 15 est disposée au voisinage de chaque transistor 13.

Des régions isolantes 17 sont formées dans la partie supérieure des caissons 5 et 7 pour isoler les transistors les uns des autres et des prises de contact. En particulier, une région isolante 17a ayant, en vue de dessus, la forme d'une bande parallèle aux caissons 5 et 7, s'étend au-dessus de la zone de jonction entre les caissons 5 et 7, isolant les transistors 9 des transistors 13. Les régions isolantes 17 et 17a sont par exemple des tranchées d'environ 100 à 300 nm de profondeur, remplies d'oxyde de silicium. De telles tranchées peuvent être formées selon un procédé couramment désigné dans la technique par le sigle STI, de l'anglais "Shallow Trench Isolation" - isolation par tranchée peu profonde.

Dans la puce 1, chaque transistor 9 du caisson 5 est, en vue de dessus, disposé à proximité d'un transistor 13 du caisson 7. Les transistors 9 et 13 voisins sont montés en inverseur, c'est-à-dire que la grille 9G du transistor 9 est connectée à la grille 13G du transistor 13, formant la borne d'entrée d'un inverseur 19, et que le drain 9D du transistor 9 est connecté au drain 13D du transistor 13, formant la borne de sortie OUT de l'inverseur 19. Les interconnexions grille-grille et drain-drain sont réalisées par des pistes conductrices non représentées, par exemple en silicium polycristallin ou en métal. A titre d'exemple, en fonctionnement, la source 9S du transistor 9 est à un potentiel d'alimentation haut Vdd, la source 13S du transistor 13 est à un potentiel d'alimentation bas Gnd, les prises de polarisation 11 du caisson 5 et 15 du caisson 7 sont respectivement au potentiel haut Vdd et au potentiel bas Gnd, et le substrat 3 est au potentiel bas Gnd.

Les inverseurs 19 constituent des cellules élémentaires de la puce 1. Ils sont reliés entre eux par des pistes conductrices non représentées, pour former des blocs mettant en oeuvre des fonctions de la puce.

Les inventeurs ont étudié les effets d'un bombardement de la puce 1 par un faisceau laser. Ils ont constaté l'apparition de courants parasites liés à la formation de paires électrons trous au niveau des jonctions PN polarisées en inverse, et notamment au niveau des jonctions PN entre le caisson 5 et le caisson 7 et entre le substrat 3 et le caisson 5. Ces courants sont susceptibles d'entraîner la mise en conduction de transistors bipolaires parasites, notamment un transistor NPN entre les prises 11 et le caisson 5 (N), le caisson 7 (P), et les régions de drain 13D (N), un transistor PNP entre les prises 15 et le caisson 7 (P), le caisson 5 (N), et les régions de drain 9D (P), un transistor PNP entre les régions de drain 9D (P), le caisson 5 (N) et le substrat 3 (P), et un transistor PNP entre les régions de source 9S (P), le caisson 5 (N) et le substrat 3 (P). Des transistors bipolaires parasites passant par les régions de source 9S et 13S des transistors MOS 9 et 13 sont également susceptibles d'être mis en conduction. Il peut en résulter diverses anomalies de fonctionnement, par exemple des fautes logiques, c'est-à-dire que la valeur du signal sur la borne de sortie OUT d'un inverseur se trouve inversée par rapport à la valeur qui devrait normalement être présente sur cette borne compte tenu du signal appliqué sur la borne d'entrée IN. Il peut aussi se produire des fautes de délai, c'est-à-dire que la commutation du signal de sortie d'un inverseur est retardée par rapport à une commutation en l'absence du faisceau laser.

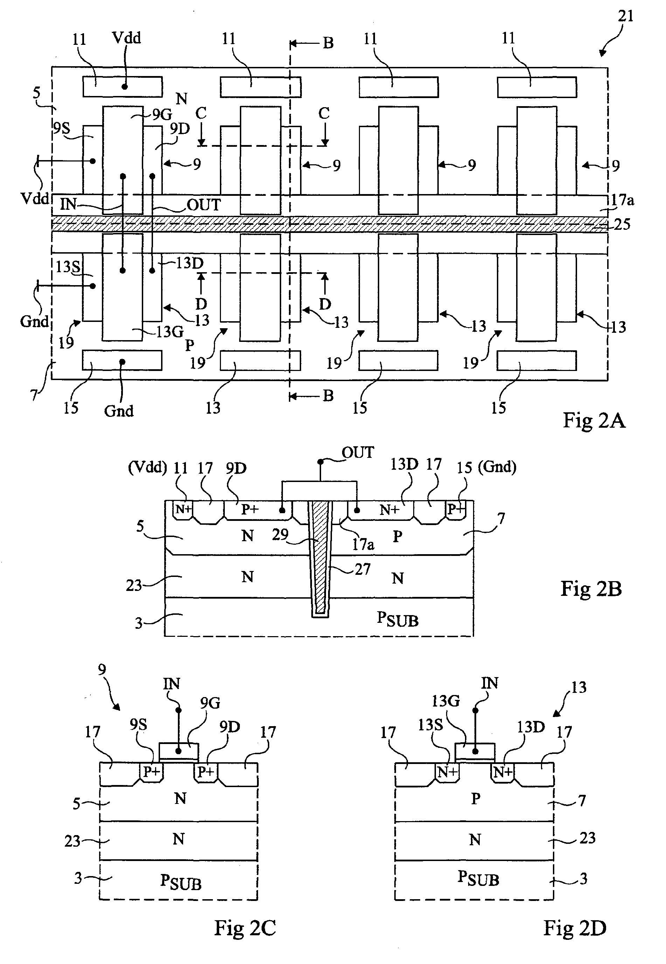

Les figures 2A à 2D représentent de façon schématique et partielle un mode de réalisation selon l'invention d'une puce 21 de circuit intégré protégée contre des attaques. La figure 2A est une vue de dessus de la puce 21, et les figures 2B, 2C et 2D sont des vues en coupe, respectivement selon les plans A-A, B-B et C-C de la figure 2A.

Comme la puce 1 des figures 1A à 1D, la puce 21 comprend des caissons parallèles de types de conductivité alternés, des transistors MOS à canal P étant formés dans les caissons de type N et des transistors MOS à canal N étant formés dans les caissons de type P. Des transistors voisins de types opposés, formés dans des caissons de types de conductivité opposés, sont montés en inverseurs, constituant des cellules élémentaires de la puce 21. Les éléments communs aux puces 1 et 21 ont été désignés par de mêmes références sur les figures et ne seront pas décrits à nouveau en détail ci-après.

Dans la puce 21, les caissons 5 et 7 reposent sur une couche de type N 23 qui fait interface entre la face inférieure des caissons et le substrat. A titre d'exemple, l'épaisseur des caissons 5 et 7 est comprise entre 0,5 et 1,5 µm, et l'épaisseur de la couche 23 est comprise entre 1 et 2 µm. On notera qu'en pratique, la couche 23 et les caissons 5, de type N, peuvent former une même région de type N.

Par ailleurs, dans la puce 21, les caissons parallèles 5 (de type N) et 7 (de type P) ne sont pas juxtaposés comme dans la puce 1 des figures 1A à 1D, mais sont séparés par des régions isolantes 25 qui s'étendent depuis la face supérieure des caissons jusqu'à la couche N 23. Les régions 25 forment des parois d'isolation latérale qui font interface entre les caissons. Il n'existe donc pas, sous les inverseurs 19, de jonction PN latérale entre les caissons 5 et 7, comme c'est le cas dans la puce 1 décrite en relation avec les figures 1A à 1D.

Dans l'exemple représenté, la région 25 traverse entièrement la couche de type N 23 jusqu'à déboucher dans le substrat 3. La région 25 peut être interrompue ou ouverte dans des régions séparant deux inverseurs 19 de la puce, ou dans des régions ne comportant pas de transistors MOS (aucune interruption ou ouverture n'est visible sur les figures 2A à 2D). De telles interruptions permettent de garantir l'uniformité de la polarisation de la couche 23.

Dans cet exemple, la région isolante 25 s'étend à partir de la face supérieure de la région isolante superficielle 17a séparant les transistors 9 du caisson 5 des transistors 13 du caisson 7. En vue de dessus (figure 2A), la région isolante 25 a la forme d'une bande, éventuellement interrompue ou ouverte dans certaines régions de la puce, parallèle aux caissons 5 et 7, de largeur inférieure à la bande 17a, et coïncidant sensiblement avec la partie centrale de la bande 17a. Ainsi, la prévision de la région isolante 25 n'entraîne pas une augmentation de la surface semiconductrice nécessaire à la réalisation de la puce. Dans une variante de réalisation, on peut se passer de la région d'isolation superficielle 17a.

La région isolante 25 est une tranchée dont les parois latérales et le fond sont revêtus par un film 27 en un matériau isolant tel que l'oxyde de silicium, cette tranchée étant remplie d'un matériau conducteur 29 tel que du silicium polycristallin. Une telle tranchée peut être formée selon un procédé couramment désigné dans la technique par le sigle DTI, de l'anglais "Deep Trench Isolation" - isolation par tranchée profonde. Toute autre méthode adaptée à former une tranchée d'isolation latérale remplie d'un matériau conducteur et suffisamment profonde pour atteindre le substrat 3 pourra être utilisée.

Sur les figures 2A à 2D, seuls deux caissons parallèles 5 et 7 ont été représentés. Toutefois, en pratique, la puce 21 peut comprendre un grand nombre de caissons parallèles de types de conductivité alternés, séparés les uns des autres par des régions d'isolation latérales 25. Ainsi, dans la puce 21, les transistors 9 et 13 constitutifs d'un même inverseur 19 sont séparés par une portion de tranchée isolante 25.

Les essais effectués par les inventeurs ont montré que le bombardement d'une puce du type décrit en relation avec les figures 2A à 2D par un faisceau laser ne provoque pas d'anomalies de fonctionnement. En présence du faisceau laser, il apparaît bien un courant parasite relativement important dans le substrat 3, lié à la formation de paires électrons trous au niveau de la jonction PN polarisée en inverse formée entre le substrat 3 et la couche 23. Toutefois, ce courant parasite n'a pas d'incidence sur le fonctionnement des circuits de la puce. En particulier, du fait de la présence de la couche 23 et des régions isolantes 25, aucun transistor bipolaire parasite n'est susceptible d'être mis en conduction sous l'effet du faisceau laser. Dans le cas où la région d'isolation latérale 25 comprend des ouvertures dans certaines régions de la puce, il subsiste, dans ces régions, des jonctions PN latérales entre les caissons 5 et 7. Toutefois, ces jonctions sont de faible surface et suffisamment éloignées des inverseurs 19 pour ne pas permettre l'injection de fautes dans des circuits de la puce.

Ainsi, dans la puce 21, la couche 23 et les régions isolantes 25 sont des éléments d'un dispositif de protection contre des attaques permettant non pas de détecter une attaque puis de protéger, aliéner, ou détruire les données sensibles de la puce comme le font les dispositifs de protection usuels, mais d'empêcher la conséquence de l'attaque, c'est-à-dire l'injection de fautes ou anomalies de fonctionnement dans les circuits de la puce.

Un avantage du dispositif de protection proposé est qu'il permet de protéger la puce non seulement contre des attaques laser, mais aussi contre d'autres types d'attaque, par exemple des attaques par injection de fautes à l'aide d'un champ électromagnétique.

Un autre avantage d'un tel dispositif de protection est qu'il n'entraîne pas une augmentation de la surface de silicium nécessaire pour réaliser la puce.

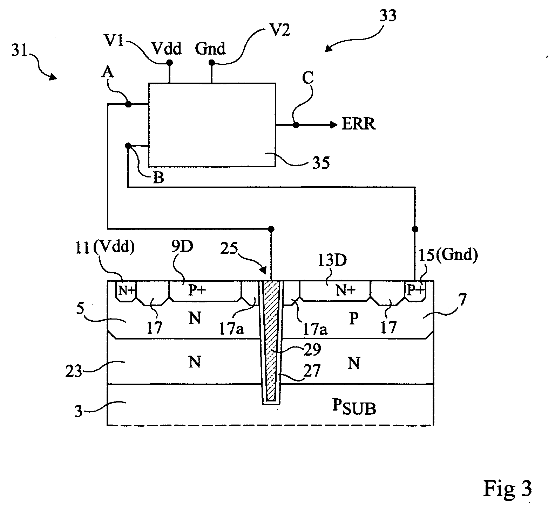

La figure 3 est une vue en coupe dans le même plan que la figure 2B, représentant de façon schématique et partielle un mode de réalisation selon l'invention d'une puce de circuit intégré protégée contre des attaques. La puce 31 de la figure 3 comprend un dispositif de protection permettant non seulement d'empêcher l'injection de fautes, comme dans la puce 21 décrite en relation avec les figures 2A à 2D, mais aussi de détecter une éventuelle gravure localisée du substrat depuis sa face arrière, du type réalisé lors d'une attaque par prise de contact depuis la face arrière du substrat. La puce 31 comprend les mêmes éléments que la puce 21 décrite en relation avec les figures 2A à 2D, et comprend en outre un circuit 33 de détection de gravure localisée.

Le matériau conducteur 29 remplissant une tranchée à parois isolées 25 disposée entre des caissons 5 et 7 voisins, constitue une électrode commune à une pluralité de capacités parasites. En particulier, on observe des capacités parasites entre le matériau 29 et le caisson 5, entre le matériau 29 et le caisson 7, entre le matériau 29 et la couche 23, et entre le matériau 29 et le substrat 3. D'autres capacités parasites existent, par exemple au niveau des jonctions PN entre le substrat 3 et la couche 23, et entre le caisson 7 et la couche 23.

La gravure localisée du substrat lors d'une attaque par prise de contact depuis la face arrière modifie de façon significative la valeur des capacités parasites. En effet, avant de pouvoir prendre des contacts, l'attaquant doit accéder à la face arrière des caissons 5 et 7. Il doit donc retirer totalement le substrat 3 et la couche de type N 23 dans la zone attaquée. Ainsi, la capacité parasite entre le matériau 29 et le substrat 3 peut disparaître totalement, et les autres capacités peuvent être fortement réduites.

Pour détecter une gravure localisée du substrat par la face arrière, on propose ici de détecter une variation d'une capacité dont une électrode est constituée par le matériau conducteur 29. On propose par exemple de détecter une variation de la capacité équivalente formée entre le matériau 29 et le substrat 3 de la puce, ou entre le matériau 29 et une prise de polarisation 11 ou 15 d'un caisson de la puce.

Si une variation de capacité susceptible de correspondre à une attaque est détectée, diverses mesures peuvent être prises, de protection, d'aliénation, ou de destruction des données confidentielles de la puce. A titre d'exemple, une mesure de capacité peut être effectuée à chaque mise sous tension de la puce, pour vérifier que le substrat n'a pas été gravé, ou bien de façon continue, lorsque la puce est alimentée.

Sur la figure 3, le circuit 33 a été représenté sous la forme d'un bloc comprenant des bornes d'alimentation V1 et V2, des bornes d'entrée A et B, et une borne de sortie C. En fonctionnement, les bornes V1 et V2 sont reliées respectivement aux potentiels d'alimentation haut Vdd et bas Gnd. Les bornes A et B sont reliées respectivement à deux points entre lesquels on souhaite mesurer la valeur d'une capacité. Dans cet exemple, la borne A est reliée au matériau conducteur 29 de remplissage de la tranchée 25, et la borne B est reliée à une prise 15 de polarisation du caisson 7 juxtaposé à la tranchée 25. La borne C fournit un signal (ERR) dont la valeur dépend de la valeur de la capacité équivalente entre les bornes A et B. Le signal ERR permet de déterminer si le substrat 3 de la puce 31 a été gravé localement autour ou à proximité de la tranchée 25.

Le circuit 33 est par exemple un oscillateur en anneau comprenant une pluralité d'inverseurs CMOS en série, dans lequel la sortie du dernier inverseur est reliée à l'entrée du premier inverseur, et dans lequel un noeud commun aux premier et second inverseurs est relié à une électrode de la capacité à mesurer. La fréquence de résonnance de l'oscillateur est liée à la valeur de la capacité entre les bornes A et B. Une gravure du substrat dans la zone comprenant la tranchée 25 entraîne une augmentation de la fréquence de résonnance de l'oscillateur. Pour détecter une gravure du substrat, on mesure la valeur de la fréquence de résonance de l'oscillateur et on compare cette fréquence à une fréquence de référence.

En variante, on pourra utiliser tout autre type d'oscillateur dont la fréquence de résonnance dépend de la capacité entre les bornes A et B, par exemple un oscillateur de type RLC. Plus généralement, tout circuit adapté à détecter une variation ou modification de la valeur d'une capacité pourra être utilisé, par exemple un pont diviseur capacitif.

Plusieurs circuits de détection 33 peuvent être prévus sur la puce 31. On peut par exemple associer à chaque région 25 de séparation des caissons de la puce, ou à chaque tronçon d'une région 25 de séparation, un circuit de détection 33. On peut alternativement prévoir un circuit de détection 33 associé à plusieurs régions 25 distinctes. On peut aussi ne prévoir des circuits de détection 33 que dans certaines zones sensibles de la puce. On notera qu'une gravure localisée du type réalisée lors d'une attaque par prise de contact sur la face arrière porte généralement, mais pas nécessairement, sur une surface correspondant à une pluralité de caissons 5 et 7 voisins. Le nombre et l'agencement des circuits de détection 33 sont de préférence choisis en fonction des dimensions des caissons 5 et 7, et donc de l'espacement entre les tranchées 25, de façon à pouvoir détecter tous les types de gravures localisées.

Un avantage du dispositif de protection décrit en relation avec la figure 3 est qu'il offre une sécurité accrue, puisqu'en plus de détecter une attaque par prise de contact depuis la face arrière du substrat, il permet d'empêcher l'injection de faute dans la puce.

On peut prévoir un mode de réalisation simplifié permettant la détection de gravure localisée du substrat depuis sa face arrière, mais ne comprenant pas la fonction de protection de la puce contre l'injection de faute. Dans ce cas, on peut se passer de la couche de type N 23 s'étendant sous les caissons. Les tranchées 25 traversent alors les caissons 5 et 7 et débouchent directement dans le substrat 3.

Des modes de réalisation particuliers de la présente invention ont été décrits. Diverses variantes et modifications dans le cadre de la portée des revendications apparaîtront à l'homme de l'art.

En particulier, on a décrit ci-dessus des modes de réalisation d'une puce de circuit intégré protégée contre des attaques laser, cette puce comprenant des caissons parallèles de types de conductivité alternés formés dans la partie supérieure d'un substrat semiconducteur, les caissons étant séparés les uns des autres par des régions isolantes 25. L'invention ne se restreint pas à l'exemple particulier décrit ci-dessus dans lequel les caissons ont, en vue de dessus, la forme de bandes parallèles. Par caissons parallèles, on entend ici plus généralement des caissons voisins disposés de façon qu'une face d'un premier caisson soit en regard d'une face du second caisson et sensiblement parallèle à cette face. Dans la structure proposée, une tranchée d'isolation 25, comprenant éventuellement des zones d'interruption, fait interface entre lesdites faces sensiblement parallèles.

De plus, on a décrit ci-dessus des exemples de puces de circuit intégré formées à partir d'un substrat de type P. L'homme de l'art saura adapter le dispositif de protection proposé à une puce formée à partir d'un substrat de type N.

## Revendications

1. Puce de circuit intégré comprenant une pluralité de caissons (5, 7) parallèles de types de conductivité alternés, formés dans la partie supérieure d'un substrat semiconducteur (3) d'un premier type de conductivité (P), et un dispositif de protection contre des attaques comprenant :
entre les caissons, des tranchées (25) à parois isolées remplies d'un matériau conducteur (29), lesdites tranchées s'étendant depuis la face supérieure des caissons jusqu'au substrat (3) ; et
un circuit (33) adapté à détecter une modification de la capacité parasite formée entre ledit matériau conducteur (29) et une région (3, 11, 15) de la puce.

2. Puce selon la revendication 1, comprenant en outre une couche (23) du second type de conductivité (N), s'étendant sous ladite pluralité de caissons (5, 7), entre la face inférieure desdits caissons et le substrat (3).

3. Puce selon la revendication 1 ou 2, dans laquelle la profondeur desdites tranchées (25) est supérieure à 2 µm.

4. Puce selon l'une quelconque des revendications 1 à 3, dans laquelle le matériau conducteur (29) est du silicium polycristallin.

5. Puce selon l'une quelconque des revendications 1 à 4, dans laquelle ledit circuit (33) comprend un oscillateur dont la fréquence de résonnance dépend de la valeur de ladite capacité parasite, et des moyens de comparaison de ladite fréquence de résonnance à une valeur de référence.

6. Puce selon l'une quelconque des revendications 1 à 5, dans laquelle ladite région est le substrat (3) de la puce.

7. Puce selon l'une quelconque des revendications 1 à 5, dans laquelle ladite région est une prise de contact de polarisation (15) d'un caisson (7) du premier type de conductivité (P).

8. Puce selon l'une quelconque des revendications 1 à 7, comprenant, dans chaque caisson (7) du premier type (P), une pluralité de transistors MOS (13) à canal du second type de conductivité (N), et dans chaque caisson (5) du second type (N), une pluralité de transistors MOS (9) à canal du premier type (P), des transistors voisins de caissons voisins étant reliés en inverseurs (19).

## Patentansprüche

1. Ein integriertes Schaltungs-Chip, welches eine Vielzahl von parallelen Vertiefungen (5, 7) von alternativen Leitungstypen geformt in dem oberen Teil eines Halbleitersubstrats (3) eines ersten Leitfähigkeitstyps (P) und eine Vorrichtung zum Schutz gegenüber Angriffen aufweist, wobei folgendes vorgesehen ist:
zwischen den Vertiefungen Gräben (25) mit isolierten Wänden, gefüllt mit einem leitenden Material (29), wobei sich die Gräben von der oberen Oberfläche (Oberseite) der Vertiefungen zu dem Substrat (3) erstrecken; und
eine Schaltung (33), die in der Lage ist eine Modifikation der Streukapazität zu detektieren, die zwischen dem erwähnten leitenden Material (29) und einer Region (3, 11, 15) des Chips gebildet ist.

2. Das Chip nach Anspruch 1, wobei ferner folgendes vorgesehen ist: eine Schicht (23) des zweiten Leitfähigkeitstyps (N), die sich unter die erwähnte Vielzahl von Vertiefungen (5, 7) erstreckt und zwar zwischen der unteren Oberfläche (Unterseite) der Vertiefungen und dem Substrat (3).

3. Das Chip nach Anspruch 1 oder 2, wobei die Tiefe der Gräben (25) größer ist als 2 µm.

4. Das Chip nach einem der Ansprüche 1 bis 3, wobei das leitende Material (29) Polysilizium ist.

5. Das Chip nach einem der Ansprüche 1 bis 4, wobei die Schaltung (33) einen Oszillator aufweist, der eine Resonanzfrequenz besitzt, abhängig von dem Wert der Streukapazität und ferner mit Mitteln zum Vergleichen der erwähnten Resonanzfrequenz mit einem Bezugswert.

6. Das Chip nach einem der Ansprüche 1 bis 5, wobei die erwähnte Region das Chip-Substrat (3) ist.

7. Das Chip nach einem der Ansprüche 1 bis 5, wobei die Region eine Vorspannkontaktregion (15) einer Vertiefung (7) des ersten Leitfähigkeitstyps (P) ist.

8. Das Chip nach einem der Ansprüche 1 bis 7, wobei Folgendes vorgesehen ist: in jeder Vertiefung (7) des ersten Typs (P) eine Vielzahl von MOS-Transistoren (13) mit einem Kanal des zweiten Leitfähigkeitstyps (N), und in jeder Vertiefung (5) des zweiten Typs (N) eine Vielzahl von MOS-Transistoren (9) mit einem Kanal des ersten Typs (P), wobei benachbarte Transistoren benachbarter Vertiefungen als Inverter (19) geschaltet sind.

## Claims

1. An integrated circuit chip comprising a plurality of parallel wells (5, 7) of alternated conductivity types formed in the upper portion of a semiconductor substrate (3) of a first conductivity type (P), and a device of protection against attacks comprising:
between the wells, trenches (25) with insulated walls filled with a conductive material (29), the trenches extending from the upper surface of the wells to the substrate (3); and
a circuit (33) capable of detecting a modification of the stray capacitance formed between said conductive material (29) and a region (3, 11, 15) of the chip.

2. The chip of claim 1, further comprising a layer (23) of the second conductivity type (N), extending under said plurality of wells (5, 7), between the lower surface of said wells and the substrate (3).

3. The chip of claim 1 or 2, wherein the depth of said trenches (25) is greater than 2 µm.

4. The chip of any of claims 1 to 3, wherein the conductive material (29) is polysilicon.

5. The chip of any of claims 1 to 4, wherein said circuit (33) comprises an oscillator having a resonance frequency depending on the value of said stray capacitance, and means for comparing said resonance frequency with a reference value.

6. The chip of any of claims 1 to 5, wherein said region is the chip substrate (3).

7. The chip of any of claims 1 to 5, wherein said region is a bias contact region (15) of a well (7) of the first conductivity type (P).

8. The chip of any of claims 1 to 7, comprising, in each well (7) of the first type (P), a plurality of MOS transistors (13) having a channel of the second conductivity type (N) and, in each well (5) of the second type (N), a plurality of MOS transistors (9) having a channel of the first type (P), neighboring transistors of neighboring wells being connected as inverters (19).
